# EUROPEAN PATENT APPLICATION

(11) **EP 4 529 012 A1**
(43) Date of publication of application: **26.03.2025**
(21) Application number: 24188557.3
(22) Date of filing: 15.07.2024
(51) Int. Cl.: H02M 3/158, H02M 3/07, H02M 1/00, H02M 7/00, G06F 1/26, H01L 23/498

(54) **VOLTAGE REGULATOR PARTITIONING ACROSS STACKED DIE**

(30) Priority: 25.09.2023 US 202318474147
(71) Applicant: INTEL Corporation, Santa Clara, CA 95054 (US)
(72) Inventor: RAVICHANDRAN, Krishnan, Saratoga 95070 (US); RADHAKRISHNAN, Kaladhar, Chandler 85226 (US); DOUGLAS, Jonathan, Cave Creek 85331 (US); KRISHNAMURTHY, Harish, Beaverton 97006 (US); AHMED, Khondker, Hillsboro 97124 (US); KIM, Suhwan, Portland 97225 (US); DESAI, Nachiket, Portland 97229 (US); BUTZEN, Nicolas, Portland 97229 (US)
(74) Representative: Viering, Jentschura & Partner mbB Patent- und Rechtsanwälte

(57) **Abstract**

Embodiments herein relate to a voltage regular (VR) formed from dies stacked on a package base layer. The VR can include a first part on a first die and a second part on a second die, where the different parts are selected based on characteristics of the respective die such as their voltage domains or technologies. In a capacitor-based VR, an input capacitor and switches subject to a relatively high input voltage can be provided in the first die, while a flying capacitor, output capacitor and switches subject to a relatively low output voltage can be provided in the second die. In an inductor-based VR, an inductor and one or more switches subject to a relatively high input voltage can be provided in the first die, while an output capacitor subject to a relatively low output voltage can be provided in the second die.

## Description

### FIELD

The present application generally relates to the field of voltage regulators.

### BACKGROUND

Computing devices often rely on voltage converters, also referred to as voltage regulators, to obtain power. For example, direct current (DC)-to-DC voltage converters can convert a power supply at one DC voltage to another, typically lower DC voltage. A voltage converter can convert the main supply voltage of a computing device, such as 12-48 V, down to lower voltages, such as about 1 V. The lower voltages can be used by various components in the computing device, such as a Universal Serial Bus (USB) interface, memory such as dynamic random access memory (DRAM) and processing resources such as a central processing unit (CPU). However, it is challenging to supply power in an efficient and cost-effective manner.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts an example voltage regulator (VR) system 100 which includes a voltage regulator 110 and power management unit (PMU) 125, in accordance with various embodiments.
FIG. 2 depicts a cross-sectional view of an example implementation of a stack 200 including a package base layer 210, a first die 220 which includes a first VR (VR1) and a second die 230 which includes second, third and fourth VRs (VR2, VR3 and VR4, respectively), in accordance with various embodiments.
FIG. 3 depicts a cross-sectional view of an example implementation of a stack 300 including a package base layer 310, a first die 320 which includes a first part of a first VR 321 (VR1a) and a second die 330 which includes a second part of the first VR (VR1b) and second, third and fourth additional VRs (VR2, VR3 and VR4, respectively), in accordance with various embodiments.
FIG. 4 depicts a circuit diagram of a capacitor-based VR 400 as an example implementation of VR1a and VR1b in FIG. 3, in accordance with various embodiments.
FIG. 5A depicts a circuit diagram of an inductor-based VR 500 as an example implementation of VR1a and VR1b in FIG. 3, in accordance with various embodiments.
FIG. 5B depicts a circuit diagram of another inductor-based VR 550 as an example implementation of VR1a, VR1b and VR1c in FIG. 3, in accordance with various embodiments.
FIG. 6A depicts a circuit diagram of another inductor-based VR 600 as an example implementation of VR1a and VR1b in FIG. 3, in accordance with various embodiments.
FIG. 6B depicts a circuit diagram of another inductor-based VR 640 as an example implementation of VR1a, VR1b and VR1c in FIG. 3, in accordance with various embodiments.
FIG. 7A depicts an example stack 700 including a first part VR1a of a voltage regulator 701 on a first die 720 and a second part VR1b of the VR on a second die 730, where VR1a includes an inductor-based buck converter 702 and VR1b includes a switched-capacitor converter 703, in accordance with various embodiments.
FIG. 7B depicts an example stack 740 including a first part VR1a of a voltage regulator 741 on a first die 720 and a second part VR1b of the VR on a second die 730, where VR1a includes an inductor-based boost converter 742 and VR1b includes the switched-capacitor converter 703, in accordance with various embodiments.
FIG. 7C depicts an example stack 760 including a first part VR1a of a voltage regulator 761 on a first die 720 and a second part VR1b of the VR on a second die 730, where VR1a includes an inductor-based buck-boost converter 762 and VR1b includes the switched-capacitor converter 703, in accordance with various embodiments.
FIG. 8 illustrates an example of components that may be present in a computing system 850 for implementing the techniques (e.g., operations, processes, methods, and methodologies) described herein, in accordance with various embodiments.

### DETAILED DESCRIPTION

The current and power demands of integrated circuits (ICs) are increasing due to workloads such as artificial intelligence (AI)/machine learning (ML), and high performance computing (HPC), which can require wafer scale computing.

One solution involves three-dimensional ICs which can be used to maximize the compute density. However, given the increasing power density requirements of these systems, the power delivery and the associated thermals of the die-stack complex present a challenge. The power delivery can include an Integrated Voltage Regulator (IVR), whose efficiency and power density key performance indicators (KPIs) dictate the overall performance, power, area, and cost of the product.

The solutions herein can exploit transistor and process capabilities across all dies within the stack to maximize the efficiency and power density of the VR while still regulating and complying with the needs of the domain. The solutions can partition the various stages within a VR across the die stacks to get the best of all process nodes to further enhance efficiency and current density and alleviate thermal hot spots, unlike traditional lumped implementations of the VR.

The VR can be implemented across multiple dies to exploit different transistor technologies (e.g., thin-oxide, thick-oxide, deep N-well etc.) and different passive technologies (e.g., inductor, capacitor and resistor offerings) across the dies to improve efficiency or reduce the footprint of the VR. The controller of the VR can be implemented on any die to lower the area and power of the implementation as demanded by the application in battery operated systems or even to gain performance like proximity to a Power Management Unit (PMU) for faster state transitions to lower overall power and enhance overall performance. A PMU can be provided as a microcontroller that governs various power functions such as charging batteries, controlling power to other integrated circuits, shutting down unnecessary system components when they are left idle, and controlling sleep and power functions.

Compared to other solutions in which multiple stages of an IVR are part of a single die, a number of advantages can be achieved by distributing the components of an IVR across multiple dies according to the characteristics of the die including their voltage domains.

A first advantage is improved efficiency. Transistors of the VR can be located in a die in which their figures of merit are optimized. For example, different active devices such as transistors can have different voltage blocking capabilities. The voltage blocking capability of a transistor refers to the maximum voltage that can be applied to the transistor without damaging it. The voltage blocking capability of a transistor may be specified by the manufacturer, for example. It can be correlated to the transistor size, for example. If a transistor requires the capability to block a larger voltage, it can be provided in a die with a technology which is more suited to a larger transistor. If a transistor requires only the capability to block a smaller voltage, it can be provided in a die with a technology which is more suited to a smaller transistor. Given the better transistor figure of merit and given that voltage blocking capabilities for transistors in a VR can differ, the VR can be implemented across dies to reduce area and improve the switching and conduction losses, thereby improving efficiency. Also, since different process nodes across different foundries (which can produce different chips which are combined in a stack) offer different passive technologies, those can be further exploited to enhance the efficiency of the VR.

A second advantage is improved bandwidth of the VR. Since the transistors are optimally used, the effective switching frequency can be increased at iso-efficiency, thereby improving the bandwidth of the system.

A third advantage is proximity to PMU. Given that the VR controller can be co-located with the PMU, state transition logic can be communicated faster to the VR and with increased bandwidths of the VR itself, the overall entry and exit latency can be minimized, thereby improving performance and enhancing efficiency. Co-location of the controller on the same die as the PMU can also reduce pin count. Or, the number of available pins can be increased to improve the power delivery network (PDN).

A fourth advantage is potential resilience to parasitics. Since circuits within the VR are optimized across dies, the current transfer across dies could be higher if the VR is switching, which could also improve resilience to parasitics and reduce the number of power pins needed.

A fifth advantage is that further deep N-well offerings across process nodes can also be exploited to enable body biasing and further optimize power and improve efficiency.

A sixth advantage is cost savings. Fuses and DFx (Design for Debug, Test, Manufacturing, and/or Validation) circuitry for the VR can also be optimized to save area and product cost.

These and other features will be further apparent in view of the following discussion.

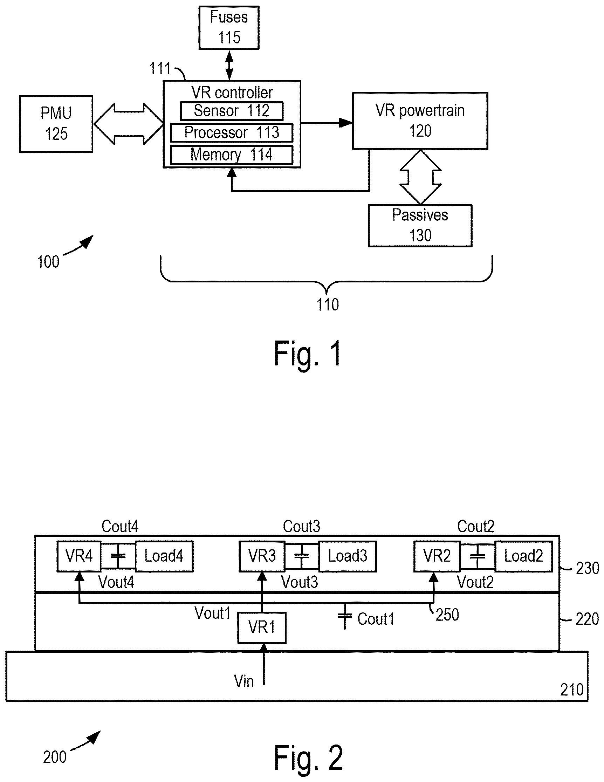

FIG. 1 depicts an example voltage regulator (VR) system 100 which includes a voltage regulator (VR) 110 and power management unit (PMU) 125, in accordance with various embodiments. The VR includes a VR powertrain 120, e.g., switches, which interacts with passives 130, e.g., passive devices such as inductors and/or capacitors, as charge-storing element. A VR controller 111 (a control circuit) is configured to control the VR powertrain such as by specifying a duty cycle for the switches in the powertrain. The VR controller includes a sensor 112, a processor 113 and a memory 114. The memory stores instructions to be executed by the processor. The sensor is capable of sensing an output voltage of the VR and implementing a control loop to regulate the output voltage.

The fuses 115 store data use for calibration for various analog circuitry to ensure optimal performance of the controller. The data in the fuses is read in by the VR controller.

The PMU 125 can communicate with one or more VRs such as to coordinate Dynamic Voltage and Frequency Scaling (DVFS) and other efficiency measures. DVFS involves adjusting power and speed settings on a computing device's processors, controller chips and peripheral devices to optimize resource allotment for tasks and maximize power saving when those resources are not needed. The PMU can be provided on a system-on-a-chip (SoC), in one possible approach, which is external to the stack.

In one approach, the multiple stages of the VR 100 are part of a single die implementation. In another approach, multiple VRs are provided across multiple dies. However, this requires regulating each VR along the various die stacks, making the power delivery inefficient. Additionally, decoupling requirements at the input and output of each VR could cost a large silicon area, making the overall solution costly and not realizable. In some cases, a platform implementation can provide the powertrain and driver integrated together as a DrMOS (driver and MOSFET module on an IC), with the controller ICs as separate entities on a board.

FIG. 2 depicts a cross-sectional view of an example implementation of a stack 200 including a package base layer 210, a first die 220 which includes a first VR (VR1) and a second die 230 which includes second, third and fourth VRs (VR2, VR3 and VR4, respectively), in accordance with various embodiments. This is an example implementation of a power delivery system where multiple VRs are in a 3D IC stack. The VRs are implemented across the die stacks but each VR on each die is complete and contains all elements of the VR co-located on the same die. As noted, explicit decoupling needs might make this system impractical to implement.

The stack includes a package base layer which can be mounted on a board such as a motherboard or other printed circuit board and includes, on its underside, conductive points such as a ball grid array for communicating with circuits on the board. The package base layer can include conductive paths such as vias to couple the conductive points to an overlying die such as the die 220 such as to input a voltage or ground the VR. Each die in turn can similarly include conductive points on its underside to connect to an underlying layer/die.

In this example, VR1 receives an input voltage Vin from the package base layer. VR1 provides an output voltage Vout1 on a path 250, which in turn is an input voltage for each of the VRs in the die 230. An output capacitor Cout1 is also provide in the die 220 to improve the stability of the output voltage. The die 230 may be a load die as depicted where the load which is driven by each VR is in the same die as the VR. The loads can include one or more circuits which draw power from the outputs of a VR. In another option, the load is at a location outside the die 230 and the stack. In this example, VR2, VR2 and VR4 output voltages Vout2, Vout3 and Vout4, respectively, and have output capacitors Cout2, Cout3 and CVout4, respectively, with loads Load2, Load3 and Load4, respectively. The different VRs VR2-VR4 can each provide a different output voltage, in one approach to suit the needs of the respective loads. The capacitors are coupled in parallel with the respective loads.

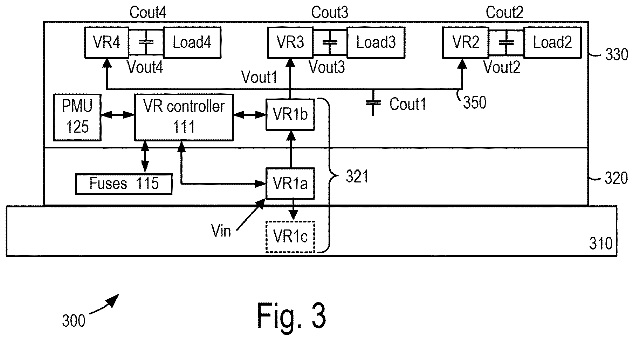

FIG. 3 depicts a cross-sectional view of an example implementation of a stack 300 including a package base layer 310, a first die 320 which includes a first part of a first VR 321 (VR1a) and a second die 330 which includes a second part of the first VR (VR1b) and second, third and fourth additional VRs (VR2, VR3 and VR4, respectively), in accordance with various embodiments. Optionally, the first VR 321 includes a third part (VR1c) in the package base layer. VR1a receives an input voltage Vin from the package base layer. VR1a includes components (e.g., active devices such as switches/transistors and/or passive devices such as inductors or capacitors) which communicate with active and/or passive devices in VR1b in die 330 and optionally with active and/or passive devices in VR1c in the package base layer. VR1b provides Vout1, the output of VR1, on a path 350 as inputs to VR2, VR2 and VR4 as in FIG. 2. The VRs can be buck converters, for example, which convert an input DC voltage to a lower DC voltage.

The VR controller 111 and PMU 125 can also be located on the die 330, in one approach, to optimize their performance, while the fuses 115 are located on the die 320 to minimize costs. The proximity of the PMU and the VR controller helps improve performance.

In one approach, the die 320 is configured to handle higher voltages, such as Vin, and is suitable for components such as fuses. The die 320 can be lower cost than the die 330, which is configured to optimize performance for the circuits of the load, such as processors and memory devices. The die 330 may be configured to handle lower voltages, such as Vout1<Vin. Accordingly, active and/or passive devices of the VR 321 that are subject to a higher maximum voltage can be provided in the die 320 while active and/or passive devices of the VR that are subject to a lower maximum voltage can be provided in the die 330. The ability to handle a high voltage may be based on the device size, materials and other process factors associated with the die. The PMU and VR controller are also more suited for the die 330 and its lower voltage domain as the components of the PMU and VR controller are typically designed for such lower voltage domains. Thus, the first part (VR1a) of the voltage regulator may be in a higher voltage domain than a voltage domain of the second part (VR1b) of the voltage regulator. The voltage domain refers, e.g., to the voltage applied to the components of the die.

It is also possible for the die 320 and 330 to comprise different materials. For example, the die 320 can comprise a Gallium Nitride (GaN) substrate which can handle a relatively high voltage domain, while the die 330 can comprise a silicon substrate which can handle a relatively low voltage domain.

Generally, the VR 321 is partitioned across the die stack to exploit process node advantages of each die. The VR can be divided into two stages, VR1a and VR1b, or three stages, VR1a, VR1b and Vr1c. As mentioned, VR1a can be the stage that requires transistors blocking higher voltages (transistors having a first voltage blocking capability) and VR1b can be the stage that requires transistors that only need to block lower voltages (transistors having a second voltage blocking capability, different than the first voltage blocking capability) . By optimally partitioning the VR to where VR1a is on the base die that is an older and more mature process node with better high voltage transistors, and where VR1b is at a more advanced process node, the KPIs of the overall VR implementation can be increased relative to the comparative single-die example of FIG. 2. Similarly, advanced process nodes could also have better capacitor technologies like MiM (metal-insulator-metal) and hence the capacitor needs can all come from the more advanced top die.

Other examples of optimality are as follows. First, the VR can be either a fully capacitive converter or an inductor-based converter. Second, the VR can be a buck, boost, or a buck-boost converter. Third, the VR on a die can also be a hybrid converter that leverages passives across the die stack and package embedded passives as optimal to maximize VR KPIs. Fourth, the controller could be a voltage mode or current mode as in the case of an inductive or hybrid converter and can be a single bound hysteretic controller as in the case of a switched capacitor VR. Fifth, the inductive passives of a VR could be top-metal spirals (formed in the top meal layer of the die 320 or 330, racetrack AC Inductance (ACI)/Coax-MILs (a coaxial magnetic composite core inductor), vertical solenoids with and without magnetic material, while the capacitors can include Multilayer Ceramic Capacitors (MLCCs), Surface Mount Device (SMD) capacitors, package embedded Deep Trench Capacitors (DTCs), on-die DTCs or MIM technology that is monolithic or could be hybrid bonded from a passive interposer die.

The VR 321 of FIG. 3 can have many different configurations. A few example configurations are provided below.

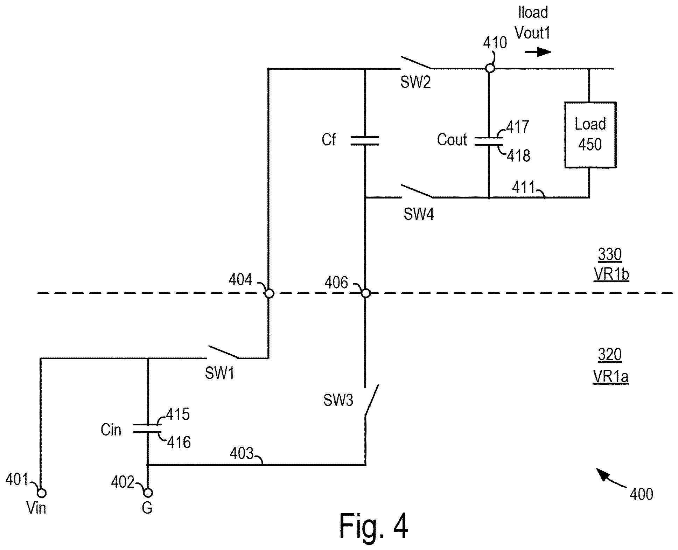

FIG. 4 depicts a circuit diagram of a capacitor-based VR 400 as an example implementation of VR1a and VR1b in FIG. 3, in accordance with various embodiments. As noted, VR1a is formed in the die 320 and VR1b is formed in the die 330. The two parts or stages of the VR are connected by nodes/conductive points 404 and 406 between the dies. This example VR is configured as a single-stage charge pump with a single flying capacitor. A charge pump generally refers to a switching voltage converter that employs an intermediate capacitive storage element which is sometimes referred to as a flying capacitor or a charge transfer capacitor. One or more flying capacitors can be used. The charge pump is configured to provide Vout1>Vin in this example.

An input node 401 receives an input voltage Vin. A set of switches SW1-SW4 are controlled by a control circuit to transfer charge from the input node to Cf, and from Cf to an output node 410. Vout1 is a resulting voltage at the output node and Iload is a current drawn by a load 450. The switches may be MOSFETs, BJTs, or relay switches, for example. SW1 connects the top conductor of Cf to the input node 401 to receive a charge from Vin. SW2 connects the top conductor of Cf to the output node 410, SW4 connects the bottom conductor of Cf to the path 411, and SW3 connects the bottom conductor of Cf to a ground node 402 via a path 403. The input node 401 and the ground node 402 may be coupled to corresponding points in the package base layer, for example.

In a charging phase of Cf, SW1 is closed and SW2 is open so that Cf is charged via SW1. Further, SW4 is closed and S3 is open so that the bottom conductor of Cf is connected to the path 411. In a discharging phase of Cf, SW1 is open and SW2 is closed, so that Cf is discharged, at least in part, to the output node via SW2. Further, SW3 is closed and S4 is open so that the bottom conductor of Cf is connected to the ground node.

The VR controller provides the switches with appropriate control signals to provide Vout1 at a desired level. The VR controller can include a sensor (see also FIG. 1) which monitors Vout1 at the output node via a feedback path. The VR controller can adjust the on/off times (duty cycle) of the switches to regulate Vout1 at a target level. In this example, the VR includes a single control loop to regulate Vout1. The additional VRs, VR2-VR4 can include their own respective control loops to regulate their outputs.

The VR is partitioned so that SW1 and SW3, which are subject to the relatively high voltage Vin, are in the die 320, and the switches SW2 and SW4, which are subject to the relatively low voltage of Vout, are in the die 330. The capacitors could be located in either die but it is efficient for Cin to be located in die 320, close to the input node and for Cout to be located in die 330, close to the load. Cf can be located in die 330 where it is subject to the lower voltage of Vout1 and close to the load. This configuration also minimizes the number of connections between the die 320 and 330.

In one implementation, the first part of the voltage regulator comprises an input capacitor Cin, a first switch SW1 coupled to a first side 415 of the input capacitor and a second switch SW3 coupled to a second side 416 of the input capacitor, and the second part of the voltage regulator comprises a flying capacitor Cf, a third switch SW2 coupled to a first side 417 of the flying capacitor and a fourth switch SW4 coupled to a second side 418 of the flying capacitor.

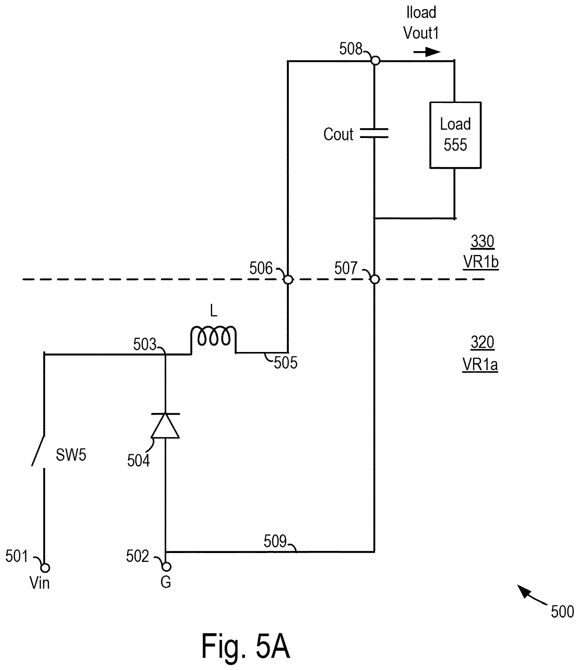

FIG. 5A depicts a circuit diagram of an inductor-based VR 500 as an example implementation of VR1a and VR1b in FIG. 3, in accordance with various embodiments. The two parts or stages of the VR are connected by nodes/conductive points 506 and 507 between the die. The VR comprises a single-switch, SW5, in this example. The VR includes an inductor L with an input end 503 and an output end 505. The input end is coupled by SW5, also referred to as a high side switch, to an input node 501, which receives Vin. A diode 504 is coupled between ground and the input end of the inductor. The output end 505 of the inductor is coupled to an output node 508 of the VR via the conductive point 506 to provide Vout1 to a load 555, which in turn is coupled to the ground node 502 by a ground path 509. When SW5 is closed, charge is stored in the inductor and when SW5 is open, charge is transferred from the inductor to the output node 508. SW5 is closed according to a duty cycle such that a larger duty cycle results in a larger Vout.

The VR is partitioned so that SW5, the inductor and the diode, which are subject to the relatively high voltage Vin, are in the die 320. Additionally, the inductor often requires a significant amount of space so that die 320 is more appropriate. Cout is located in die 330, close to the load. This configuration also minimizes the number of connections between the die 320 and 330.

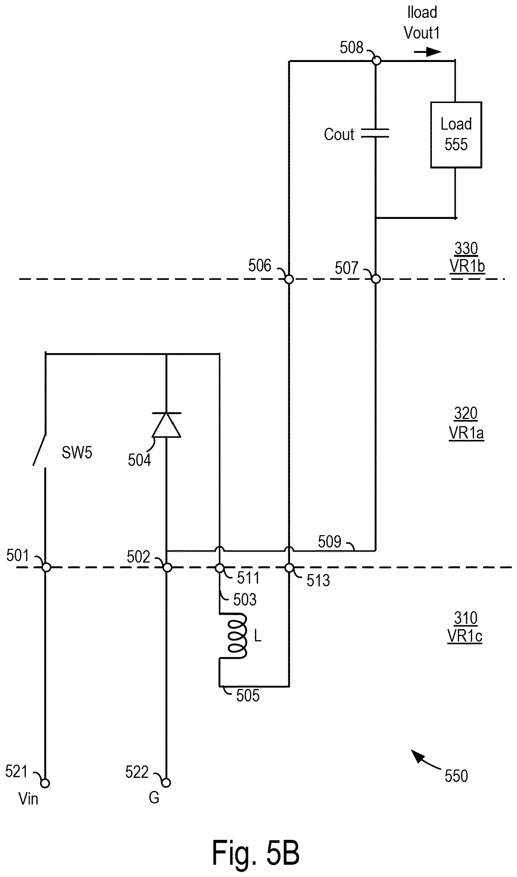

FIG. 5B depicts a circuit diagram of another inductor-based VR 550 as an example implementation of VR1a, VR1b and VR1c in FIG. 3, in accordance with various embodiments. The VR is similar to the VR of FIG. 5A but locates the inductor L in or on the package base layer 310. This can be more appropriate when the inductor has a size and/or format which make it unsuitable or not optimal for fabrication on the die 320. This approach also frees up space in the die 320. The VR include three parts or stages. The parts on the package base layer 310 and the first die 320 are connected by nodes/conductive points 511 and 513 and the parts on the first die 320 and the second die 330 are connected by the nodes/conductive points 506 and 507.

As in FIG. 5A, the VR includes the inductor L with the input end 503 and the output end 505. The input end 503 of the inductor is coupled by the switch SW5 to the input node 501 between the die 320 and the package base layer 310, via the conductive point 511. The input node 501 is coupled to an input node 521 of the package base layer. The diode 504 is coupled between ground and the input end of the inductor. The output end 505 of the inductor is coupled to the output node 508 via the conductive points 513 and 506 to provide Vout1 to the load 555, which in turn is coupled to the ground node 502 by the ground path 509. The ground node 502 is coupled to another ground node 522 of the package base layer. The conductive points 511 and 513 are also between the die 320 and the package base layer 310.

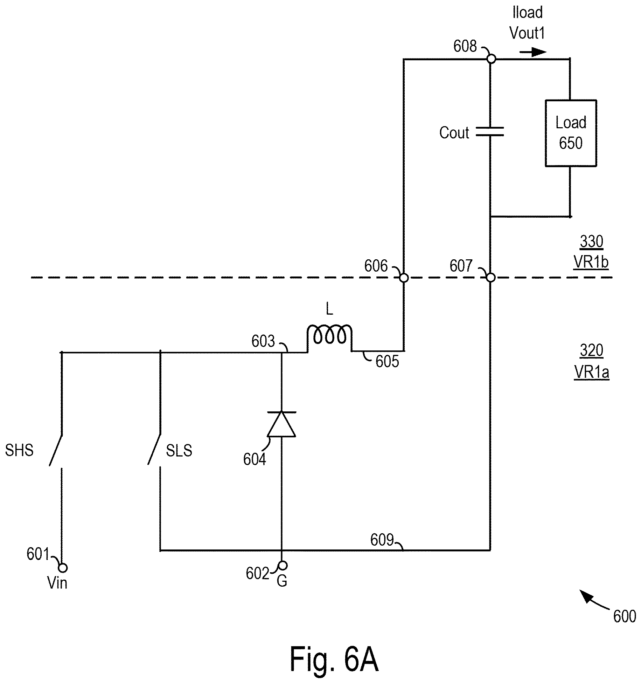

FIG. 6A depicts a circuit diagram of another inductor-based VR 600 as an example implementation of VR1a and VR1b in FIG. 3, in accordance with various embodiments. The two parts or stages of the VR are connected by nodes/conductive points 606 and 607 between the die. The VR comprises two switches, including a high-side switch SHS and a low-side switch SLS in this example. The VR includes an inductor L with an input end 603 and an output end 605. The input end is coupled by SHS to an input node 601, which receives Vin, and by SLS to a ground node 602. A diode 604 is coupled between ground and the input end of the inductor. The output end 605 of the inductor is coupled to an output node 608 of the VR via the conductive point 606 to provide Vout1 to a load 650, which in turn is coupled to the ground node 602 by a ground path 609. When SHS is closed, SLS is open, and charge is stored in the inductor. When SHS is open, SLS is closed, and charge is transferred from the inductor to ground. SHS and SLS are controlled according to a duty cycle such that a larger duty cycle results in a larger Vout.

The VR is partitioned so that SHS, SLS, the inductor and the diode, which are subject to the relatively high voltage Vin, are in the die 320. Cout is located in die 330, close to the load.

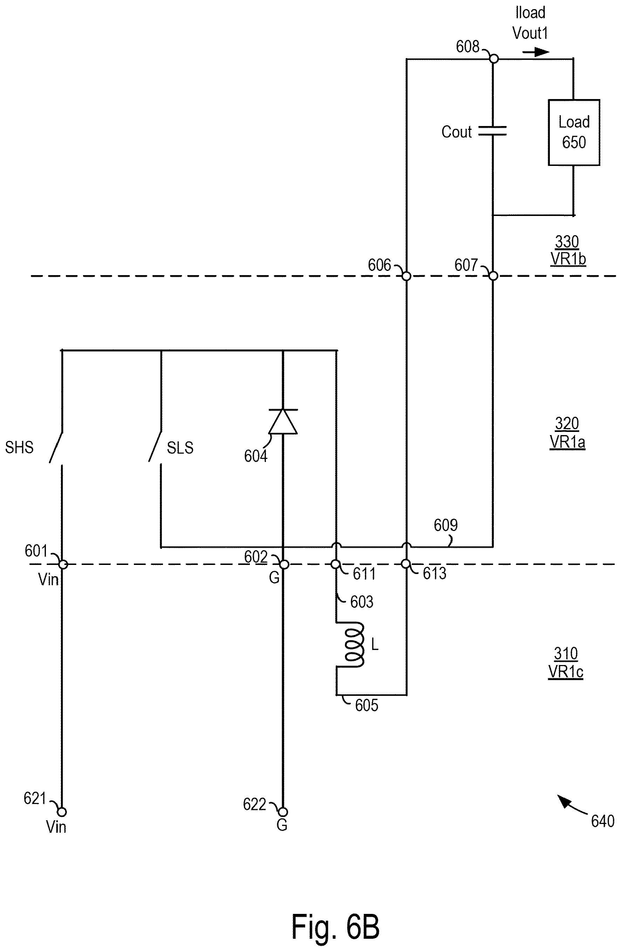

FIG. 6B depicts a circuit diagram of another inductor-based VR 640 as an example implementation of VR1a, VR1b and VR1c in FIG. 3, in accordance with various embodiments. The VR is similar to the VR of FIG. 6A but locates the inductor L in or on the package base layer 310. The VR include three parts or stages. The parts on the package base layer 310 and the first die 320 are connected by nodes/conductive points 611 and 613 and the parts on the first die 320 and the second die 330 are connected by the nodes/conductive points 606 and 607.

As in FIG. 6A, the VR includes the inductor L with the input end 603 and the output end 605. The input end 603 of the inductor is coupled by the switch SHS to the input node 601 between the die 320 and the package base layer 310, via the conductive point 611. The input node 601 in turn is coupled to an input node 621 of the package base layer. The input end 603 of the inductor is also coupled by the switch SLS to the ground node 602 between the die 320 and the package base layer 310, via the conductive point 611. The ground node 602 in turn is coupled to a ground node 622 of the package base layer. The diode 604 is coupled between ground and the input end of the inductor. The output end 605 of the inductor is coupled to the output node 608 of the VR via the conductive points 613 and 606 to provide Vout1 to the load 650, which in turn is coupled to the ground node 602 by the ground path 909. The conductive points 611 and 613 are also between the die 320 and the package base layer 310.

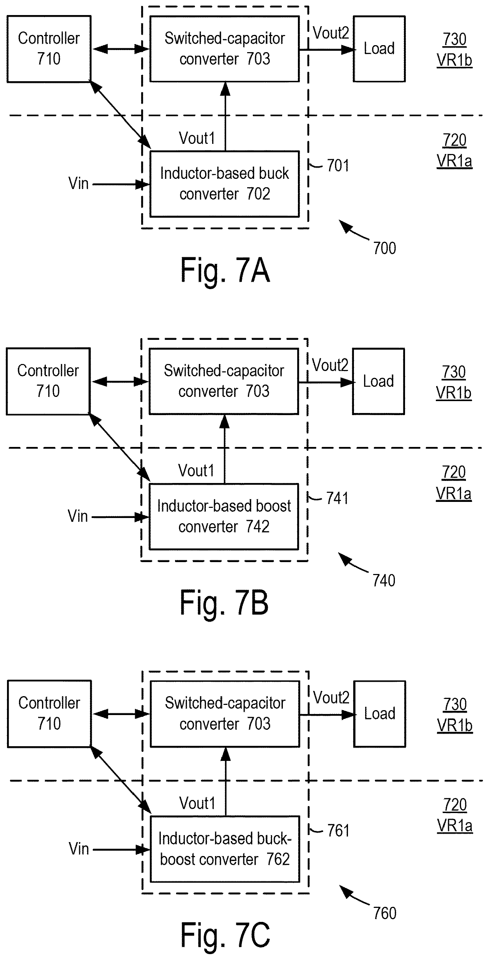

In further examples, an inductor-based voltage converter such as shown in FIG. 5A-6B can be combined with a downstream switched-capacitor voltage converter such as in FIG. 4. The switched-capacitor converter can be on the lower voltage die while the inductor-based voltage converter is on the higher voltage die. This is different than the inclusion of a 2:1 or 3:1 divider followed by a buck converter since there is a single controller in this new combination and so it becomes a multi-stage VR as opposed to a multi-VR system such as shown in FIG 2. The inductor-based voltage converter can be a buck converter, boost converter or buck-boost converter such as depicted below. For example, in FIGs. 7A-7C, a common controller 710 can be used to control the two parts of the VR to provide Vout1 and Vout2 at desired levels.

FIG. 7A depicts an example stack 700 including a first part VR1a of a voltage regulator 701 on a first die 720 and a second part VR1b of the VR on a second die 730, where VR1a includes an inductor-based buck converter 702 and VR1b includes a switched-capacitor converter 703, in accordance with various embodiments.

FIG. 7B depicts an example stack 740 including a first part VR1a of a voltage regulator 741 on a first die 720 and a second part VR1b of the VR on a second die 730, where VR1a includes an inductor-based boost converter 742 and VR1b includes the switched-capacitor converter 703, in accordance with various embodiments.

FIG. 7C depicts an example stack 760 including a first part VR1a of a voltage regulator 761 on a first die 720 and a second part VR1b of the VR on a second die 730, where VR1a includes an inductor-based buck-boost converter 762 and VR1b includes the switched-capacitor converter 703, in accordance with various embodiments.

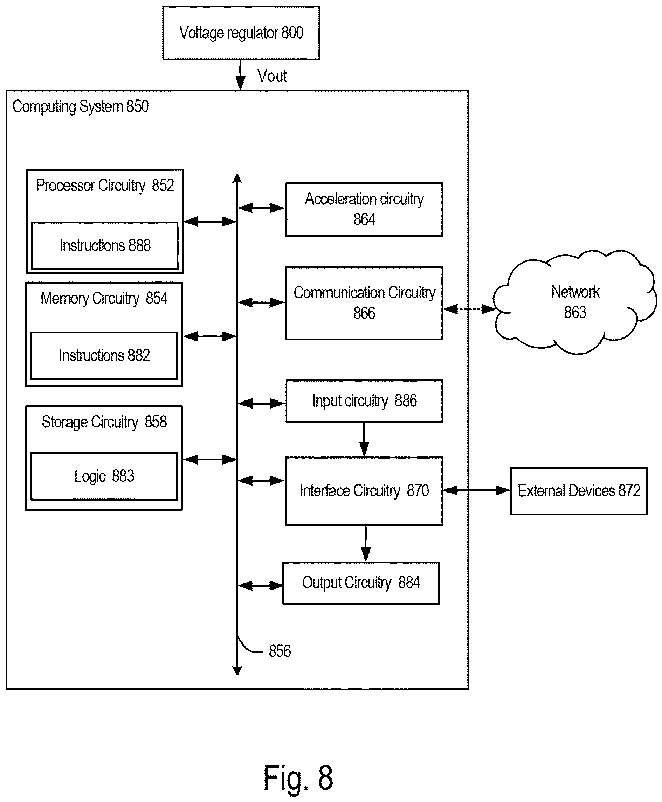

FIG. 8 illustrates an example of components that may be present in a computing system 850 for implementing the techniques (e.g., operations, processes, methods, and methodologies) described herein, in accordance with various embodiments. The voltage regulator 800 may provide a voltage Vout1 to one or more of the components of the computing system 850. The VR may be controlled by control signals provided by the processor circuitry 852. The VR may include any of the VRs discussed herein including those in FIGs. 3-6B.

The memory circuitry 854 may store instructions and the processor circuitry 852 may execute the instructions to perform the functions described herein.

The computing system 850 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 850, or as components otherwise incorporated within a chassis of a larger system. For one embodiment, at least one processor 852 may be packaged together with computational logic 882 and configured to practice aspects of various example embodiments described herein to form a System in Package (SiP) or a System on Chip (SoC).

The system 850 includes processor circuitry in the form of one or more processors 852. The processor circuitry 852 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 852 may include one or more hardware accelerators (e.g., same or similar to acceleration circuitry 864), which may be microprocessors, programmable processing devices (e.g., FPGA, ASIC, etc.), or the like. The one or more accelerators may include, for example, computer vision and/or deep learning accelerators. In some implementations, the processor circuitry 852 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 852 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 852 may be coupled with or may include memory/storage and may be configured to execute instructions stored in the memory/storage to enable various applications or operating systems to run on the platform 850. The processors (or cores) 852 is configured to operate application software to provide a specific service to a user of the platform 850. In some embodiments, the processor(s) 852 may be a special-purpose processor(s)/controller(s) configured (or configurable) to operate according to the various embodiments herein.

As examples, the processor(s) 852 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 852 may be a part of a system on a chip (SoC), System-in-Package (SiP), a multi-chip package (MCP), and/or the like, in which the processor(s) 852 and other components are formed into a single integrated circuit, or a single package, such as the Edison^{™} or Galileo^{™} SoC boards from Intel^{®} Corporation. Other examples of the processor(s) 852 are mentioned elsewhere in the present disclosure.

The system 850 may include or be coupled to acceleration circuitry 864, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 864 may comprise logic blocks or logic fabric and other interconnected resources that may be programmed (configured) to perform various functions, such as the procedures, methods, functions, etc. of the various embodiments discussed herein. In such implementations, the acceleration circuitry 864 may also include memory cells (e.g., EPROM, EEPROM, flash memory, static memory (e.g., SRAM, antifuses, etc.) used to store logic blocks, logic fabric, data, etc. in LUTs and the like.

In some implementations, the processor circuitry 852 and/or acceleration circuitry 864 may include hardware elements specifically tailored for machine learning and/or artificial intelligence (AI) functionality. In these implementations, the processor circuitry 852 and/or acceleration circuitry 864 may be, or may include, an AI engine chip that can run many different kinds of AI instruction sets once loaded with the appropriate weightings and training code. Additionally or alternatively, the processor circuitry 852 and/or acceleration circuitry 864 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 852 and/or acceleration circuitry 864 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 970 provided by Huawei^{®}, and/or the like. In some hardware-based implementations, individual subsystems of system 850 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 850 also includes system memory 854. Any number of memory devices may be used to provide for a given amount of system memory. As examples, the memory 854 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 854 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 854 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 858 provides persistent storage of information such as data, applications, operating systems and so forth. In an example, the storage 858 may be implemented via a solid-state disk drive (SSDD) and/or high-speed electrically erasable memory (commonly referred to as "flash memory"). Other devices that may be used for the storage 858 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 854 and/or storage circuitry 858 may also incorporate three-dimensional (3D) cross-point (XPOINT) memories from Intel^{®} and Micron^{®}.

The memory circuitry 854 and/or storage circuitry 858 is/are configured to store computational logic 883 in the form of software, firmware, microcode, or hardware-level instructions to implement the techniques described herein. The computational logic 883 may be employed to store working copies and/or permanent copies of programming instructions, or data to create the programming instructions, for the operation of various components of system 850 (e.g., drivers, libraries, application programming interfaces (APIs), etc.), an operating system of system 850, one or more applications, and/or for carrying out the embodiments discussed herein. The computational logic 883 may be stored or loaded into memory circuitry 854 as instructions 882, or data to create the instructions 882, which are then accessed for execution by the processor circuitry 852 to carry out the functions described herein. The processor circuitry 852 and/or the acceleration circuitry 864 accesses the memory circuitry 854 and/or the storage circuitry 858 over the interconnect (IX) 856. The instructions 882 direct the processor circuitry 852 to perform a specific sequence or flow of actions, for example, as described with respect to flowchart(s) and block diagram(s) of operations and functionality depicted previously. The various elements may be implemented by assembler instructions supported by processor circuitry 852 or high-level languages that may be compiled into instructions 888, or data to create the instructions 888, to be executed by the processor circuitry 852. The permanent copy of the programming instructions may be placed into persistent storage devices of storage circuitry 858 in the factory or in the field through, for example, a distribution medium (not shown), through a communication interface (e.g., from a distribution server (not shown)), over-the-air (OTA), or any combination thereof.

The IX 856 couples the processor 852 to communication circuitry 866 for communications with other devices, such as a remote server (not shown) and the like. The communication circuitry 866 is a hardware element, or collection of hardware elements, used to communicate over one or more networks 863 and/or with other devices. In one example, communication circuitry 866 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 866 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 856 also couples the processor 852 to interface circuitry 870 that is used to connect system 850 with one or more external devices 872. The external devices 872 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 850, which are referred to as input circuitry 886 and output circuitry 884. The input circuitry 886 and output circuitry 884 include one or more user interfaces designed to enable user interaction with the platform 850 and/or peripheral component interfaces designed to enable peripheral component interaction with the platform 850. Input circuitry 886 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 884 may be included to show information or otherwise convey information, such as sensor readings, actuator position(s), or other like information. Data and/or graphics may be displayed on one or more user interface components of the output circuitry 884. Output circuitry 884 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 850. The output circuitry 884 may also include speakers and/or other audio emitting devices, printer(s), and/or the like. Additionally or alternatively, sensor(s) may be used as the input circuitry 884 (e.g., an image capture device, motion capture device, or the like) and one or more actuators may be used as the output device circuitry 884 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 850 may communicate over the IX 856. The IX 856 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 856 may be a proprietary bus, for example, used in a SoC based system.

The number, capability, and/or capacity of the elements of system 850 may vary, depending on whether computing system 850 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 850 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a first die; a second die stacked on the first die; and a voltage regulator comprising a first part on the first die and a second part on the second die, wherein the first part comprises an input node and the second part comprises an output node.

Example 2 includes the apparatus of Example 1, further comprising a package base layer on which the first die is stacked, wherein the package base layer comprises a third part of the voltage regulator.

Example 3 includes the apparatus of Example 1 or 2, further comprising one or more additional voltage regulators on the second die, wherein the output node is coupled to the one or more additional voltage regulators.

Example 4 includes the apparatus of any one of Examples 1-3, wherein: the first part of the voltage regulator comprises an input capacitor coupled to the input node, a first switch coupled to a first side of the input capacitor and a second switch coupled to a second side of the input capacitor; and the second part of the voltage regulator comprises a flying capacitor, a third switch coupled to a first side of the flying capacitor and a fourth switch coupled to a second side of the flying capacitor.

Example 5 includes the apparatus of any one of Examples 1-4, wherein: the first part of the voltage regulator comprises a switch coupled to the input node, and an inductor coupled to the switch; and the second part of the voltage regulator comprises an output capacitor coupled to the inductor.

Example 6 includes the apparatus of any one of Examples 1-5, further comprising a package base layer on which the first die is stacked, wherein: the package base layer comprises a third part of the voltage regulator; the first part of the voltage regulator comprises a switch coupled to the input node; the third part of the voltage regulator comprises an inductor coupled to the switch; and the second part of the voltage regulator comprises an output capacitor coupled to the inductor.

Example 7 includes the apparatus of any one of Examples 1-6, wherein: the first part of the voltage regulator comprises a high-side switch coupled to the input node, a low-side switch coupled to the input node, and an inductor coupled to the high-side switch and the low-side switch; and the second part of the voltage regulator comprises an output capacitor coupled to the inductor.

Example 8 includes the apparatus of any one of Examples 1-7, further comprising a package base layer on which the first die is stacked, wherein: the package base layer comprises a third part of the voltage regulator; the first part of the voltage regulator comprises a high-side switch coupled to the input node and a low-side switch coupled to the input node; the third part of the voltage regulator comprises an inductor coupled to the high-side switch and the low-side switch; and the second part of the voltage regulator comprises an output capacitor coupled to the inductor.

Example 9 includes the apparatus of any one of Examples 1-8, wherein the first part of the voltage regulator is in a higher voltage domain than a voltage domain of the second part of the voltage regulator.

Example 10 includes the apparatus of any one of Examples 1-9, further comprising at least one of an integrated circuit, a System on Chip, a System in Package or a computing device in which the first die, second die and voltage regulator are provided, wherein the computing device comprises at least one of a processor circuitry, a memory circuitry, a storage circuitry, an acceleration circuitry, a communication circuitry, an input circuitry, an output circuitry, an interface circuitry or an external device.

Example 11 includes the apparatus of any one of Examples 1-10, wherein the first part comprises an inductor-based voltage converter and the second part comprises a switched-capacitor-based voltage converter.

Example 12 includes a voltage regulator, comprising: one or more active devices having a first voltage blocking capability; one or more active devices having a second voltage blocking capability, different than the first voltage blocking capability, wherein the one or more active devices having the first voltage blocking capability are on a first die in a stack, and the one or more active devices having the second voltage blocking capability are on a second die in the stack; and conductive points between the first and second die to couple the one or more active devices having the first voltage blocking capability to the one or more active devices having the second voltage blocking capability.

Example 13 includes the voltage regulator of Example 12, wherein: the first voltage blocking capability is greater than the second voltage blocking capability; and a voltage domain of the first die is greater than a voltage domain of the second die.

Example 14 includes the voltage regulator of Example 12 or 13, further comprising an inductor coupled to the one or more active devices having the first voltage blocking capability.

Example 15 includes the voltage regulator of Example 14, wherein the inductor is in the first die or in a package base layer of the stack.

Example 16 includes the voltage regulator of any one of Examples 12-15, further comprising: an input capacitor coupled to the one or more active devices having the first voltage blocking capability; and a flying capacitor coupled to the one or more active devices having the second voltage blocking capability.

Example 17 includes the voltage regulator of any one of Examples 12-16, further comprising an input capacitor coupled to the one or more active devices having the first voltage blocking capability and an output capacitor coupled to the one or more active devices having the second voltage blocking capability.

Example 18 includes an apparatus, comprising: a first die; a second die stacked on the first die; a voltage regulator comprising a first part on the first die and a second part on the second die; a controller for the voltage regulator, wherein the controller is on the first die and is coupled to the first part and to the second part; and fuses coupled to the controller, wherein the fuses are on the first die.

Example 19 includes the apparatus of Example 18, wherein an output node of the voltage regulator is coupled to one or more additional voltage regulators on the second die.

Example 20 includes the apparatus of Example 18 or 19, wherein a voltage domain of the first die is greater than a voltage domain of the second die.

Example 21 includes a method, comprising: receiving an input voltage at an input node of a voltage regulator, wherein the voltage regulator comprises a first part on a first die and a second part on a second die, and the second die is stacked on the first die; at the voltage regulator, converting the input voltage to an output voltage at an output node of the voltage regulator, wherein the input node is in the first die and the output node is in the second die.

Example 22 includes the method of Example 21, wherein the first part of the voltage regulator is in a higher voltage domain than a voltage domain of the second part of the voltage regulator.

Example 23 includes a non-transitory machine-readable storage including machine-readable instructions that, when executed, cause a processor or other circuit or computing device to implement method of Example 21 or 22.

Example 24 includes a computer program comprising instructions which, when the program is executed by a computer, cause the computer to carry out the method of Example 21 or 22.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a first die;
a second die stacked on the first die; and
a voltage regulator comprising a first part on the first die and a second part on the second die, wherein the first part comprises an input node and the second part comprises an output node.

2. The apparatus of claim 1, further comprising a package base layer on which the first die is stacked, wherein the package base layer comprises a third part of the voltage regulator.

3. The apparatus of claim 1 or 2, further comprising one or more additional voltage regulators on the second die, wherein the output node is coupled to the one or more additional voltage regulators.

4. The apparatus of any one of claims 1-3, wherein:
the first part of the voltage regulator comprises an input capacitor coupled to the input node, a first switch coupled to a first side of the input capacitor and a second switch coupled to a second side of the input capacitor; and
the second part of the voltage regulator comprises a flying capacitor, a third switch coupled to a first side of the flying capacitor and a fourth switch coupled to a second side of the flying capacitor.

5. The apparatus of any one of claims 1-4, wherein:
the first part of the voltage regulator comprises a switch coupled to the input node, and an inductor coupled to the switch; and
the second part of the voltage regulator comprises an output capacitor coupled to the inductor.

6. The apparatus of any one of claims 1-5, further comprising a package base layer on which the first die is stacked, wherein:
the package base layer comprises a third part of the voltage regulator;
the first part of the voltage regulator comprises a switch coupled to the input node;
the third part of the voltage regulator comprises an inductor coupled to the switch; and
the second part of the voltage regulator comprises an output capacitor coupled to the inductor.

7. The apparatus of any one of claims 1-6, wherein:
the first part of the voltage regulator comprises a high-side switch coupled to the input node, a low-side switch coupled to the input node, and an inductor coupled to the high-side switch and the low-side switch; and
the second part of the voltage regulator comprises an output capacitor coupled to the inductor.

8. The apparatus of any one of claims 1-7, further comprising a package base layer on which the first die is stacked, wherein:
the package base layer comprises a third part of the voltage regulator;
the first part of the voltage regulator comprises a high-side switch coupled to the input node and a low-side switch coupled to the input node;
the third part of the voltage regulator comprises an inductor coupled to the high-side switch and the low-side switch; and
the second part of the voltage regulator comprises an output capacitor coupled to the inductor.

9. The apparatus of any one of claims 1-8, wherein the first part of the voltage regulator is in a higher voltage domain than a voltage domain of the second part of the voltage regulator.

10. The apparatus of any one of claims 1-9, further comprising at least one of an integrated circuit, a System on Chip, a System in Package or a computing device in which the first die, second die and voltage regulator are provided, wherein the computing device comprises at least one of a processor circuitry, a memory circuitry, a storage circuitry, an acceleration circuitry, a communication circuitry, an input circuitry, an output circuitry, an interface circuitry or an external device.

11. The apparatus of any one of claims 1-10, wherein the first part comprises an inductor-based voltage converter and the second part comprises a switched-capacitor-based voltage converter.

12. A method, comprising:
receiving an input voltage at an input node of a voltage regulator, wherein the voltage regulator comprises a first part on a first die and a second part on a second die, and the second die is stacked on the first die;
at the voltage regulator, converting the input voltage to an output voltage at an output node of the voltage regulator, wherein the input node is in the first die and the output node is in the second die.

13. The method of claim 12, wherein the first part of the voltage regulator is in a higher voltage domain than a voltage domain of the second part of the voltage regulator.

14. A non-transitory machine-readable storage including machine-readable instructions that, when executed, cause a processor or other circuit or computing device to implement the method of claim 12 or 13.

15. A computer program comprising instructions which, when the program is executed by a computer, cause the computer to carry out the method of claim 12 or 13.
